# EUROPEAN PATENT SPECIFICATION

(11) **EP 0 588 582 B1**
(45) Date of publication and mention of the grant of the patent: **05.11.1997**
(21) Application number: 93307196.1
(22) Date of filing: 13.09.1993
(51) Int. Cl.: G01D 11/10, G01D 7/00

(54) **Control circuit for a pointer instrument in a dashboard**
Steuerungsschaltung für ein Zeigerinstrument in einem Armaturenbrett
Circuit de commande pour une aiguille de cadran indicateur dans un tableau de bord

(30) Priority: 12.09.1992 GB 9219361
(43) Date of publication of application: 23.03.1994
(73) Proprietor: FORD MOTOR COMPANY LIMITED, Brentwood, Essex CM13 3BW (GB); FORD-WERKE AKTIENGESELLSCHAFT, 50735 Köln (DE); FORD FRANCE S. A., 92506 Rueil-Malmaison Cédex (FR)
(72) Inventor: Woodhouse, Christopher J., South Woodham Ferrers, Essex CM3 5XR (GB)
(74) Representative: Messulam, Alec Moses

(56) References cited:
- DE-A- 2 747 958
- GB-A- 2 122 773
- US-A- 4 968 930

## Description

### Field of the invention

The present invention relates to an instrument panel gauge for a vehicle for providing a an analogue representation of the value of a digital input signal, comprising a pointer, a motor for moving the pointer relative to an analogue scale, a data acquisition system for periodically receiving digital data input signals representing the desired position of the pointer in relation to the analogue scale, and a control circuit for electronically controlling the motor to simulate an analogue gauge.

### Background of the invention

Though digital instrumentation has been used in some motor vehicles, analogue displays are generally to be preferred both for aesthetic reasons and for ease of assimilation of the displayed information. Conventional analogue gauges, such as fuel gauges and engine temperature gauges are galvanometers requiring an individual input electric lead carrying a current or voltage of which the magnitude is to be displayed. Speedometers and engine revolution counters require either an electric lead or, if they are mechanically driven, a drive cable. The connections to conventional analogue instrumentation therefore call for a complex wiring harness and create a clutter of wires and cables behind the instrument panel. By contrast, digital signals can be multiplexed onto a common bus allowing considerabie simplification of the vehicle wiring.

It has previously been proposed to use digital signals to drive analogue displays. Such instruments, having a motor driven pointer, are used for example as slave clocks in buildings having a single accurate master clock which transmits digital time signals to all the slave units.

US-4,968,930 discloses a device that displays an signal using an analogue scale and a motor driven pointer. In this case, the scale is itseld a liquid crystal display to allow the same intrument to be used over a variety of ranges.

However, such display instruments present problems when used as gauges in motor vehicle display panels because their pointers tend to move abruptly and when the digital drive signals are not steady, the pointers tend to dither in a disconcerting manner.

This dithering is exaggerated because of the way in which the digital signals are produced in certain motor vehicle applications. Modern motor vehicles have computerised engine management systems which have some spare computing capacity and which also have available to them the values of parameters which are to be displayed on the instrument panel, for example the engine temperature, engine speed and vehicle speed. It is therefore inexpensive and convenient to use the engine management computer as the source of the control signals for the instrument panel. However, in such computers, priority must be given to functions such as engine fuelling and spark timing and this means that data signal sent to the instrument panel can only be updated relatively infrequently. The delay between consecutive data signals may for this reason be subject to considerable and unpredictable variation and it is this irregularity of the data signals that is a further source of hesitation in the movements of the pointers.

### Summary of the invention

With a view to mitigating the foregoing disadvantages, the present invention provides an instrument panel gauge as set forth above for a vehicle, that is characterised in that the control circuit has means for estimating the time of arrival of the next data signal, and means for setting the speed of the motor following receipt of a data signal to a value that will cause the pointer to move a predetermined fraction of the difference between its current position and its desired position in a time equal to the estimated time of arrival of the next data signal.

Preferably, the motor is a stepper motor, the speed of which is set by varying the rate at which drive pulses are supplied to it by an oscillator.

Conveniently, the pulse rate may be varied by means of a variable divider connected a fixed frequency oscillator.

### Brief description of the drawings

The invention will now be described further, by way of example, with reference to the accompanying drawings, in which:
Figure 1 is a block diagram of an instrument panel gauge of the invention,
Figure 2 is an example of a flowchart implemented in the control circuit in Figure 1, and
Figure 3 shows successive positions of the gauge pointer in achieving a rapid swing of 90°.

### Detailed description of the preferred embodiment

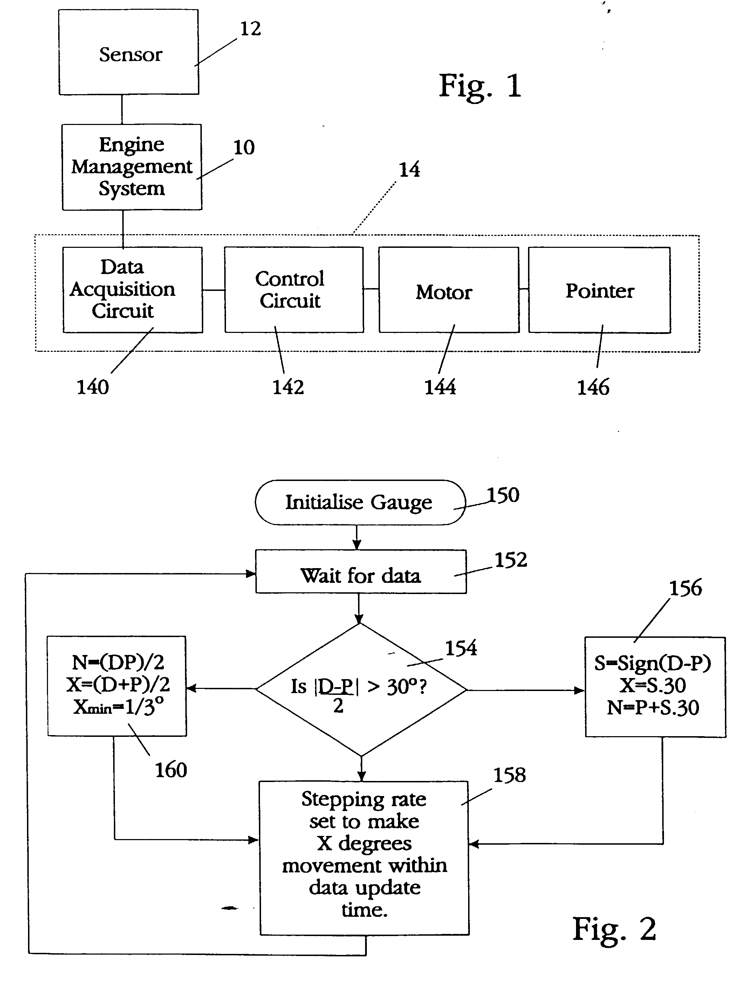

In Figure 1, a computerised engine management system 10 of a motor vehicle receives input signals from a sensor 12 and sends a digital output to an instrument panel gauge which is generally designated 14 for displaying the value of the parameter sensed by the sensor 12.

The engine management system 10 receives input from numerous sensors representing such parameters as the engine speed, coolant temperature, crankshaft angle and engine load which are required to enable the computer to control such factors as the fuel injection quantity and spark timing. The engine management system 10 need not be understood fully to permit an understanding the operation of the instrument gauge 14 and it will not therefore be described in great detail. It suffices to appreciate that some of the parameters known to the management system 10 can usefully be displayed on the instrument panel 14, for example the engine speed and coolant temperature, and it saves on duplication of components to transmit signals directly from the management system to the instrument panel gauge 14.

The management system 10 is obliged to operate in real time and this places constraints on the amount of additional processing that can be asked of it. It is convenient from its point of view to send digital signals to the instrument gauge. Another reason for resorting to digital signals for communications between the management system and the gauges is that the vehicle wiring can be simplified. These signals must be transmitted at such times as the processor of the management system 10 is not taken up with tasks of a higher priority and their transmission rate will therefore vary, being less frequent at higher engine speeds. Thus the interval between updates, though predictable, is not constant.

In the analogue display gauge 14, there is a data acquisition circuit 140 which captures digital signals intended for the gauge. The output of the acquisition circuit is supplied to a control circuit 142 which controls a motor 144, preferably a stepper motor, that drives the pointer 146 of the analogue gauge.

The circuit 140 is designed to distinguish signals intended for the instrument gauge from any other digital signals that may be transmitted on the same signal line or data bus. The output signal of the data acquisition circuit 140 indicates the desired position against the analogue scale of the pointer 146 of the gauge.

If the gauge pointer 146 were allowed to follow all changes in the value of the desired destination, its movements would be abrupt and jerky. Furthermore, the pointer would tend to dither instead of staying in any fixed position. Analogue gauges have inherent damping to avoid such movement and the control circuit 142 which controls the motor 144 driving the pointer 146 of the gauge 14 is intended to set the speed of the motor 144 in dependence upon both the present position and the desired destination of the pointer 146 in such a manner as to simulate the damped movement of an analogue gauge.

To this end, the control circuit 142 sets the speed of the motor 144 at the time arrival of each digital signal at the output of the data acquisition circuit 140 such that the pointer will have covered only a predetermined fraction, preferably one half, of the distance between its present position and its desired destination by the time that the next digital signal is expected at the output of the data acquisition circuit 140. This principle is better understood by reference to the flowchart shown in Figure 2.

At the commencement of operation, as represented by the box 150, the gauge is initialised, for example driven backwards until it reaches a fixed abutment at a known position. When data is available at the output of the acquisition circuit 140, the block 152 passes the new desired destination (D) to the comparator block 154 in which half the absolute difference between the present position (P) and the desired destination (D) is calculated and compared with a fixed maximum, in the present case 30°, this being the maximum displacement of the pointer allowed during a sampling interval (the time between new values of desired destination).

If a displacement exceeding 60° is required, within the box 156, a parameter S is assigned a value of +1 or -1, depending on the required direction of the displacement of the pointer 146, the total displacement X is limited to 30°, and the new position N of the pointer is computed as the present position P plus the displacement X. The result of this calculation is used in the box 158 to set the frequency of an oscillator connected to the stepper motor so that the motor receives the required number of pulses to move to its new position by the time that the next data signal is acquired in the block 152.

If the half desired displacement (D - P)/2 does not exceed 30° then after the comparison in block 154 flow chart branches the block 160 rather than the block 156. In this case, the required displacement X is not set to D - P but to a fraction of D - P, in this case (D - P)/2. Consequently, the pointer does not move immediately to the desired position D but to a new position N which is part way,- in this case half way, between the present and the desired position. Once again, the value X is passed on to block 158 which set the frequency of the signal sent to the stepper motor 144 so that the pointer will reach the new position N by the expected time of arrival of the next data signal from the engine management system.

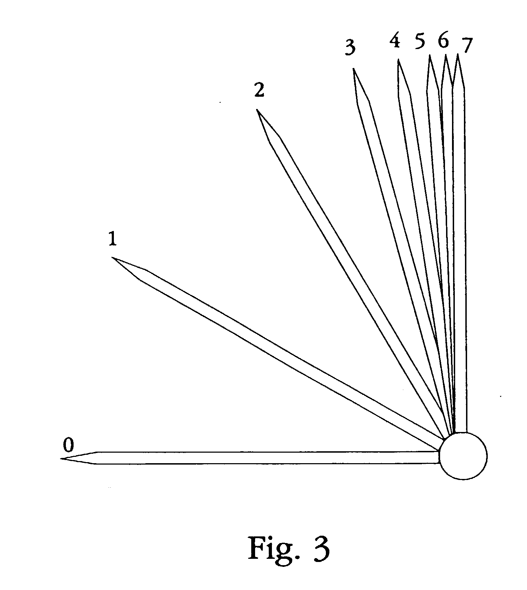

This algorithm results in the pointer 146 moving in a manner resembling a damped analogue gauge as will now be explained by reference to Figure 3.

Assuming that a signal is received while the pointer 146 is in position 0 requiring the pointer to move through 90° and that this same signal is received during the next seven acquisition intervals. The positions of the pointer 146 at the end of these intervals are shown in Figure 3 and have the values given in the following table.

| Interval | Angle Moved During Interval | Angle Remaining to Desired Destination |
|---|---|---|
| 0 | 30° | 60° |
| 1 | 30° | 30° |
| 2 | 15° | 15° |
| 3 | 7.3° | 7.7° |
| 4 | 3.6° | 4° |
| 5 | 2° | 2° |
| 6 | 1° | 1° |
| 7 | 0.66° | 0.33° |

In these calculations, a maximum resolution of 1/3° is assumed in the positioning of the pointer. Typically, the sampling interval is around 140ms so that all these steps will take place within about one second.

During the first two intervals, the displacement is restricted to 30°, thus being the maximum allowed in any one interval, regardless of the desired destination. Thereafter, in each interval the pointer advances to half way between its present position and its desired destination eventually arriving at the desired destination, within the resolution of the gauge, after approximately one second.

The resemblance between this movement and that of a damped gauge will be obvious and it will be clear that the degree of damping can be varied by using a ratio other than one half. For example, if the pointer covers two thirds of the distance between its present position and its desired destination in each interval, then the extent of damping will be reduced and if this ratio is set to one third then the extent of the damping will be increased.

Though, as earlier mentioned, the data acquisition rate does vary, the extent of the variation from one sample to the next is not large and one may predict the time of arrival of data from the engine management system from the interval between previously received samples. By varying the repetition frequency of the pulses supplied to a stepper motor to supply the desired number of pulses within the predicted interval duration and continuous control of the movement of the pointer is achieved.

Though it is desirable to vary the estimate of interval duration in a system in which the acquisition rate is relatively low, it is possible to rely on a fixed estimate when using higher acquisition rates. In this case, the data picked up by the acquisition circuit may be stored in a buffer which is sampled at regular intervals. Any loss of data will not in this case affect the stability of the display in view of the damping achieved by the control algorithm.

The speed of a motor in the case of a stepper motor is varied by controlling the repetition frequency of the drive pulses supplied to it. This can be done using a variable oscillator or a variable divider connected to a fixed frequency oscillation. It should be clear that it is not essential to the invention to use a stepper motor and any variable speed motor may alternatively be used.

## Claims

1. An instrument panel gauge for a vehicle for providing a an analogue representation of the value of a digital input signal, comprising
a pointer (146),
a motor (144) for moving the pointer (146) relative to an analogue scale,
a data acquisition system (140) for periodically receiving digital data input signals representing the desired position of the pointer (146) in relation to the analogue scale, and
a control circuit (142) for electronically, controlling the motor to simulate an analogue gauge,
characterised in that
the control circuit (142) has means for estimating the time of arrival of the next data signal, and means (158) for setting the speed of the motor following receipt of a data signal to a value that will cause the pointer (146) to move a predetermined fraction of the difference between its current position and its desired position in a time equal to the estimated time of arrival of the next data signal.

2. A gauge as claimed in claim 1, wherein the motor (144) is a stepper motor, the speed of which is set by varying the rate at which drive pulses are supplied to it by an oscillator.

3. A gauge as claimed in claim 2, wherein the pulse rate is varied by means of a variable divider connected to a fixed frequency oscillator.

## Patentansprüche

1. Eine Anzeige für das Armaturenbrett eines Fahrzeugs, zur Lieferung einer Analog-Darstellung des wertes eines Digital-Eingangssignals, bestehend aus :
einem Zeiger (146)
einem Motor (144) zum Bewegen des Zeigers (146) im Verhältnis zu einer Analog-Skala,
einem Datenerfassungs-System (140) zum regelmässigen Empfang von Digitaldaten-Eingangssignalen, die die gewünschte Position des Zeigers (146) im Verhältnis zur Analog-Skala darstellen und
einem Steuerkreis (142) zur elektronischen Steuerung des Motors, um eine Analog-Anzeige zu simulieren,
dadurch gekennzeichnet, dass :
Der Steuerkreis (142) über eine Vorrichtung zur Schätzung der Ankunftszeit des nächsten Datensignals verfügt, sowie über eine Vorrichtung (158) zur Einstellung der Geschwindigkeit des Motors nach dem Empfang eines Datensignals, auf einen Wert, der den Zeiger (146) veranlasst, sich auf einer vorbestimmten Fraktion des Unterschieds zwischen seiner normalen Position und seiner gewünschten Position zu bewegen, während einer Zeitspann, die gleichwertig mit der geschätzten Ankunftszeit des nächsten Datensignals ist.

2. Eine Anzeige nach Anspruch 1, in der der Motor (144) ein Stufenmotor ist, dessen Geschwindigkeit durch eine Veränderung des Verhältnisses, in dem Antriebsimpulse von einem Schwingungserzeuger an ihn geliefert werden, geregelt wird.

3. Eine Anzeige nach Anspruch 2, in der das Verhältnis der Impulse durch einen variablen Teiler verändert wird, der an einen festen Frequenz-Schwingungserzeuger angeschlossen ist.

## Revendications

1. Instrument de mesure de tableau de bord pour un véhicule, destiné à permettre une représentation analogique de la valeur d'un signal d'entrée numérique, comprenant
une aiguille (146),
un moteur (144) destiné à déplacer l'aiguille (146) par rapport à une échelle analogique,
un système d'acquisition de données (140) destiné à recevoir périodiquement des signaux d'entrée de données numériques représentant la position désirée de l'aiguille (146) par rapport à l'échelle analogique, et
un circuit de commande (142) destiné à commander électroniquement le moteur pour simuler un instrument de mesure analogique,
caractérisé en ce que
le circuit de commande (142) comporte un moyen destiné à estimer l'instant d'arrivée du signal de données suivant, et un moyen (158) destiné à établir la vitesse du moteur après la réception d'un signal de données à une valeur qui amènera l'aiguille (146) à se déplacer sur une fraction prédéterminée de la différence entre sa position actuelle et sa position désirée en un temps égal à celui jusqu'à l'instant estimé d'arrivée du signal de données suivant.

2. Instrument de mesure selon la revendication 1, dans lequel le moteur (144) est un moteur pas à pas, dont la vitesse est établie en faisant varier la cadence à laquelle des impulsions d'attaque lui sont appliquées grâce à un oscillateur.

3. Instrument de mesure selon la revendication 2, dans lequel la cadence des impulsions varie au moyen d'un diviseur variable relié à un oscillateur à fréquence fixe.
